# EUROPEAN PATENT APPLICATION

(11) **EP 1 225 257 A2**
(43) Date of publication of application: **24.07.2002**
(21) Application number: 02250383.3
(22) Date of filing: 21.01.2002
(51) Int. Cl.: C30B 29/36, C30B 25/02

(54) **Single crystal SiC and method of producing the same as well as SiC semiconductor device and SiC composite material**

(30) Priority: 19.01.2001 JP 2001011312
(71) Applicant: HOYA CORPORATION, Shinjuku-ku Tokyo (JP)
(72) Inventor: Yagi, Kuniaki, Oume-shi, Tokyo 198-0036 (JP); Nagasawa, Hiroyuki, Hachiouji-shi, Tokyo 192-0373 (JP)
(74) Representative: Colmer, Stephen Gary

(57) **Abstract**

A single crystal SiC layer is formed on a substrate surface by heating the substrate under existence of a raw material containing C or C and Si. SiC is deposited on the single crystal SiC layer by the vapor phase growth method or the liquid phase growth method. In the step of forming the single crystal SiC layer, the raw material is supplied in the vicinity of the surface, and the raw material in the vicinity of the surface is given a partial pressure higher at least by a predetermined rate than that of an impurity. Thus, the impurity is prevented from reaching the surface, so that the surface is prevented from being etched by the impurity.

## Description

### Background of the Invention:

This invention broadly relates to a single crystal SiC (silicon carbide) used as a substrate material of a semiconductor device and a method of producing the same as well as a SiC semiconductor device and a SiC composite material, which are capable of reducing planar defect density of SiC.

SiC is generally a semiconductor material with a wide band gap, an excellent chemical stability, and environment resistance.

Therefore, it is expected that SiC can be used under a severe condition, such as a high voltage, a high temperature, or exposure to radiation, to which a conventional semiconductor material, typically Si (silicon), is difficult to apply.

In order to produce SiC, use has been made of sublimation, LPE (liquid phase epitaxy), sputtering, CVD (Chemical Vapor Deposition), and so on.

In the sublimation as a vapor phase method, SiC as a source material is sublimated in a crucible at a temperature within a range between 2000 and 2500°C to thereby generate a sublimation gas. In an ascending flow of the sublimation gas, a seed crystal formed of a SiC single crystal is placed. Herein, the seed crystal is retained at a temperature 50-200°C lower than that of the material. In this manner, a new SiC single crystal is grown on the seed crystal. For example, the above-mentioned method is disclosed in Japanese Examined Patent Publication No. JP 7-88274 B, and Japanese Examined Patent Publication No. JP 7-91153 B.

In the LPE, a crucible containing carbon as its component element is heated to a temperature within a range of 1650-1800°C, and Si is melted in the crucible into a Si melt. Within the Si melt, SiC is generated by reaction between Si and carbon as the component element of the crucible. Then, a SiC seed crystal is contacted with the surface of the melt to thereby grow SiC. Thus, a single crystal SiC is produced. For example, this method is disclosed in Japanese Unexamined Patent Publication No. JP 7-172998 A.

In the sputtering, SiC is used as a target material to thereby deposite a SiC film on a substrate. Herein, a single crystal Si or a single crystal SiC is employed as the substrate and a substrate temperature is set to 1200°C or higher to thereby produce the single crystal SiC.

In the CVD, a raw material gas of Si and a raw material gas of carbon are supplied onto a Si substrate and are thermally reacted with each other in an atmosphere kept at normal pressure or reduced pressure so that SiC is deposited on a surface of the Si substrate. In order to obtain an SiC film having higher purity and less crystal defects, use is made of atomic layer epitaxy (ALE), as disclosed, for example, in Japanese Unexamined Patent Publication No. JP 2-262324 A. In the ALE, a Si source and a carbon source are alternately adsorbed on the substrate surface so that SiC is epitaxially-grown, reflecting the crystallinity of the substrate.

However, the above-mentioned CVD is disadvantageous in the following respect. In a substrate heating process, the substrate surface may be partially or entirely etched by an impurity gas, such as H₂O and O₂, existing in a reaction chamber before formation of SiC or at the same time with formation of SiC. Such phenomenon is caused by the following reason. In case where the partial pressure of the impurity gas, such as H₂O and O₂, in the reaction chamber is low, an oxide having a stoichiometric composition is not formed on the substrate surface but a suboxide will be formed. For example, the suboxide such as SiO is low in vapor pressure and high in volatility, and is therefore detached from the substrate surface as soon as it is formed. In other words, the substrate surface is etched. Further, in presence of a chlorine-based impurity in the chamber, chloride is volatilized from the substrate surface, thereby causing an etching phenomenon to occur, like in case of oxygen.

As a result of etching, a hole-like defect called an etch pit is inevitably formed on the substrate surface. Alternatively, another defect called a dome-like protrusion is formed on the substrate surface as a result of reaction between an etched substrate component and the raw material gas. On the substrate surface with such a defect, a single crystal SiC layer partially or entirely reflecting or copying surface orientation of the substrate is not formed but a polycrystal SiC layer will be formed. SiC grown on the polycrystal SiC layer by vapor phase reaction has planar defects with high density and is therefore difficult to be used as a semiconductor device. Herein, it should be noted that the aforementioned planar defects include a stacking fault, an antiphase domain boundary, and a twin boundary.

In the CVD , a thin single crystal SiC layer is preliminarily formed before depositing a thick SiC so as to suppress the above-mentioned etching of the substrate surface. In particular, when Si is used as the substrate, the surface of the Si substrate is heat-treated in a hydrocarbon atmosphere to form an extremely thin SiC layer having a thickness of about 10 nm. This method is referred to as surface carbonization.

In the existing surface carbonization, however, the effect of suppressing the etching of the substrate surface is varied in dependency upon the partial pressure of the impurity gas such as H₂O, O₂, and chloride in the reaction chamber. In consequence, the single crystal SiC low in defect density and usable as the semiconductor device could be not produced stably and industrially.

In order to solve the above-mentioned problems, Japanese Examined Patent Publication No. JP 8-15143 B proposes a method of forming the SiC layer by reaction between hydrocarbon and the Si substrate in a high vacuum atmosphere with remarkably low impurity concentration. However, such a method of forming the SiC layer in the high vacuum atmosphere requires a long time to obtain the high vacuum atmosphere, thus being not always suitable as a production method of the industrial level.

Further, Japanese Unexamined Patent Publication No. JP 1-162326 A proposes formation of the SiC layer by reaction between C₂H₂ and Si at the substrate temperature of 800°C~1000°C. Such a low substrate temperature reduces the formation of the etch pits and trapping of the impurities. However, in case where the substrate temperature is lowered and when growth rate is increased, a grown film has a twin crystal or a polycrystal structure and the single crystal can not be grown. In order to grow the single crystal, the growth rate must be lowered. Therefore, a long production time is inevitably required to produce a thick SiC single crystal usable for the semiconductor device. Accordingly, this method is not practical also.

### Summary of the Invention:

It is therefore an object of this invention to provide SiC which is low in planar defect density and in impurity concentration and which can be produced with excellent productivity

It is another object of this invention to provide a method for producing SiC mentioned above.

It is still another object of this invention to provide a SiC semiconductor device using SiC mentioned above.

It is yet another object of this invention to provide a SiC composite material using SiC mentioned above.

According to a first aspect of this invention, a method of producing single crystal SiC on a substrate having a surface comprises a first step of forming a thin single crystal SiC layer on the surface of the substrate by heating the substrate under existence of a raw material containing C or C and Si and a second step of depositing SiC on the single crystal SiC layer by the vapor phase growth method or the liquid phase growth method. The vapor phase growth method includes, for example, CVD and sputtering. By the use of these methods, vapor phase epitaxy can be carried out.

In the first step of forming the single crystal SiC layer, the raw material is supplied in the vicinity of the surface of the substrate. The raw material in the vicinity of the surface of the substrate is given a partial pressure higher at least by a predetermined rate than that of an impurity. Thus, the impurity is prevented from reaching the surface of the substrate, so that the surface of the substrate is prevented from being etched by the impurity.

According to a second aspect of this invention, heating the substrate in the first step of forming the single crystal SiC layer comprises a temperature elevating step. In the temperature elevating step, the partial pressure of the raw material is adjusted to a level not lower than 100 times that of the impurity. In this state, the temperature of the substrate is elevated from a first temperature Te at which etching of the surface of the substrate by the impurity is started to a second temperature not lower than a temperature at which the single crystal SiC layer is formed.

In the temperature elevating step, at least one of a temperature elevating rate and a temperature elevating time is selected within a range such that the density and the size of a defect, such as etch pits or dome-like protrusions, formed on the surface of the single crystal SiC layer are not so increased as to cause a planar defect on SiC which is deposited on the single crystal SiC layer by the vapor phase growth method or the liquid phase growth method. As described above, such defect is formed on the single crystal SiC layer because the surface of the substrate is etched by the impurity.

According to a third aspect of this invention, the material used in the first step and containing C is at least one selected from the group consisting of CₙH₂ₙ (2≦n≦3), CₙH₂ₙ₊₂ (1≦n≦3), CₙH₂ₙ₋₂ (1≦n≦3), CCl₄, CHF₃, and CF₄.

According to a fourth aspect of this invention, the material containing Si may be used in the first step in addition to the material containing C. The material containing Si is at least one selected from the group consisting of SiH₂Cl₂, SiH₄, SiCl₄, SiHCl₃, Si₂H₆, and Si₂Cl₆.

According to a fifth aspect of this invention, the material used in the first step and containing C is at least one selected from the group consisting of Si(CH₃)₄, SiH₂(CH₃)₂, SiH(CH₃)₃, Si₂(CH₃)₆, (CH₃)₃SiCl, and (CH₃)₂SiCl₂.

According to a sixth aspect of this invention, single crystal SiC is obtained by a method according to any one of the first through the fifth aspects of this invention. In the single crystal SiC, the density of defects, such as etch pits and dome-like protrusions, on a topmost surface falls within a range not higher than 10²/cm⁻².

According to a seventh aspect of this invention, single crystal SiC is obtained by a method according to any one of the first through the fifth aspects of this invention. In the single crystal SiC, the density of planar defects on a topmost surface falls within a range not higher than 10³/cm⁻².

According to an eighth aspect of this invention, single crystal SiC is obtained by a method according to any one of the first through the fifth aspects of this invention. Furthermore, another SiC is deposited on the single crystal SiC by the vapor phase growth method or the liquid phase growth method.

According to a ninth aspect of this invention, a semiconductor device comprises SiC having a predetermined concentration of dopant and obtained by adding the dopant by ion implantation into the single crystal SiC produced by the method according to any one of the first through the fifth aspects of this invention.

According to a tenth aspect of this invention, a semiconductor device comprises SiC having a predetermined concentration of dopant and obtained by adding the dopant into SiC during the second step of depositing SiC.

According to an eleventh aspect of this invention, a SiC composite material comprises a single crystal SiC produced by a method according to any one of the first through the fifth aspects of this invention and diamond or GaN formed on the single crystal SiC.

### Brief Description of the Drawings:

Figs. 1A through 1C are diagrams for explaining a method for manufacturing SiC according to an embodiment of this invention;
Fig. 2 is a schematic diagram for explaining measurement of Te;
Fig. 3 shows a relationship between the temperature elevating rate of a Si substrate and the density of etch pits and dome-like protrusions formed on a surface of a SiC layer;
Fig. 4 shows a relationship between the temperature elevating rate of the Si substrate and the size of the etch pits formed on the surface of the SiC layer;
Fig. 5 shows a SEM (Scanning Electron Microscope) image of the surface of the single crystal SiC layer formed on the Si substrate surface;
Fig. 6 shows variation of a full width at half maximum of a rocking curve of a 3C-SiC(200) peak obtained by X-ray diffraction measurement with respect to a substrate heating rate;
Fig. 7 shows a SEM image in the vicinity of the surface of a single crystal SiC layer formed on a Si substrate surface by a method of a first comparative example;
Fig. 8 shows a SEM image in the vicinity of the surface of a single crystal SiC layer formed on a Si substrate surface by a method of a second comparative example; and
Fig. 9 is a diagram showing electrical characteristics of shottky-barrier diode junction according to a third example.

### Description of Preferred Embodiments:

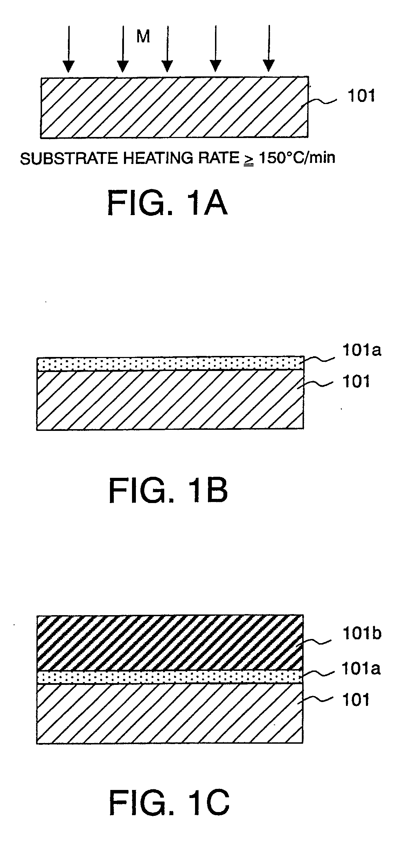

Referring now to Figs. 1A through 1C, description will be made about a method for manufacturing SiC (silicon carbide) according to one embodiment of this invention.

As illustrated in Fig. 1A, a substrate 101 is heated under existence of a raw material M containing C. Here, the raw material may contain Si in addition to C as desired. Then, as illustrated in Fig. 1 B, a thin single crystal SiC layer 101 a is formed on the surface of the substrate 101 (hereinafter, this step may be referred to as a single crystal SiC layer formation step).

Referring to Fig. 1C, a thick SiC layer 101b is deposited on the single crystal SiC layer 101a by the use of the vapor phase growth method or the liquid phase growth method (hereinafter, this step may be referred to as a SiC deposition step).

In the single crystal SiC layer formation step, the raw material M is supplied in the vicinity of the surface of the substrate 101. The raw material in the vicinity of the substrate surface is given a partial pressure not lower at a predetermined rate than that of an impurity. Thus, the impurity is prevented from reaching the substrate surface so that the substrate surface is prevented from being etched by the impurity.

Therefore, it is possible to reduce the density and the size of a defect, such as etch pits or dome-like protrusions, formed by the etching of the substrate with the impurity and to form the single crystal SiC layer high in quality and low in defect density on the substrate surface. As a result, SiC deposited on the single crystal SiC layer is given a high quality.

More specifically, heating in the single crystal SiC layer formation step comprises a temperature elevating step. In the temperature elevating step, the partial pressure of the raw material is adjusted to a level not lower than 100 times that of the impurity. In this state, the temperature of the substrate is elevated from an etching start temperature Te at which etching of the substrate surface by the impurity is started to a temperature not lower than a SiC forming temperature at which the single crystal SiC layer is formed.

In the temperature elevating step, at least one of a temperature elevating rate and a temperature elevating time is selected within a range such that the density and the size of the defect, such as the etch pits or the dome-like protrusions, formed on the surface of the single crystal SiC layer on the substrate surface are not increased to a level causing a planar defect on SiC which will be deposited on the single crystal SiC layer by the vapor phase growth method or the liquid phase growth method. Such defect is formed on the single crystal SiC layer because the surface of the substrate is etched by the impurity.

Specifically, the defect, such as the etch pits or the dome-like protrusions, formed by the etching of the substrate with the impurity occurs within a temperature range not lower than Te, and is increased with time of exposure to the impurity at the temperature not lower than Te.

In view of the above, the time of exposure to the impurity is reduced to a predetermined time period or less so that the density and the size of the defect, such as the etch pits and the dome-like protrusions, can be restricted to a predetermined level or less.

As the substrate, use can be made of Si, SiC, titanium carbide, sapphire, diamond, or the like. The temperature at which the single crystal SiC layer is formed falls within the range between about 1000 and 1100°C in case where a Si substrate is used as the substrate. By heating the substrate to the above-mentioned temperature under existence of the substance containing C or C and Si, the single crystal SiC layer with high-quality having a film thickness of about 10 nm can relatively easily be formed (for example, see C. J. Mogab et al. Journal of Applied Physics Vol. 45 (1974) P1075-).

Alternatively, in case where a substrate other than Si is used, the single crystal SiC layer with the high quality having the film thickness of about 10 nm is formed by reaction between raw material gases of Si source and carbon source at a temperature of about 800°C-1100°C.

Thus, the single crystal SiC layer with high quality can be formed by elevating the substrate temperature preferably to 1100°C or higher.

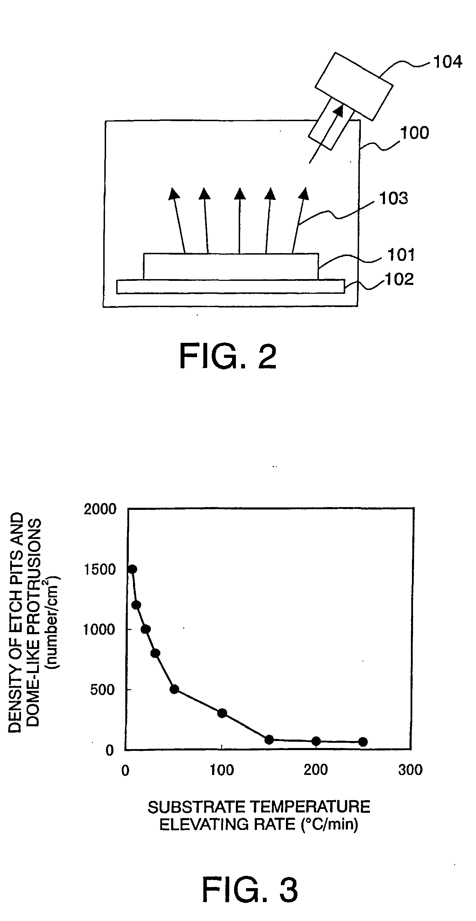

Herein, the etching start temperature Te of the substrate is measured in the following manner. As illustrated in Fig. 2, a substrate 101 is arranged in a case 100 and is heated by the use of a heating apparatus 102. In this event, the substrate temperature is elevated without supplying the raw material containing C or Si into the case 100. Consequently, the impurity alone exists in the case 100.

In the above-mentioned state, if the surface of the substrate 101 is etched by the impurity, molecules or atoms 103 constituting the substrate are detached or released from the substrate surface. Those molecules or atoms thus detached are monitored by using a quadrupole mass spectrometer 104. Herein, the etching start temperature Te is a temperature at which molecules or atoms derived from the composition of the substrate start to be detected. For example, if a Si substrate is employed, the etching start temperature Te corresponds to a temperature at which molecules or atoms derived from Si start to be detected. Alternatively, if a sapphire substrate is used, the etching start temperature Te corresponds to a temperature at which molecules or atoms derived from Al start to be detected.

Fig. 3 shows a relationship between the temperature elevating rate and the density of the etch pits and the dome-like protrusions formed on the surface of the SiC layer. In the illustrated example, the Si substrate was heated up to 1100°C in a C₂H₂ atmosphere by changing the temperature elevating rate. Herein, the partial pressure of the impurity is equal to 6 × 10⁻³ Torr. The number (density) of the etch pits or the dome-like protrusions was observed by the use of a SEM (Scanning Electron Microscope). Specifically, the etch pits and the dome-like protrusions having a diagonal length of 20 nm or more were counted.

As illustrated in Fig. 3, if the temperature elevating rate is equal to or higher than 150°C/minute, the density of the etch pits and the dome-like protrusions formed on the surface of the SiC layer is remarkably reduced so that the single crystal SiC layer with high-quality is obtained.

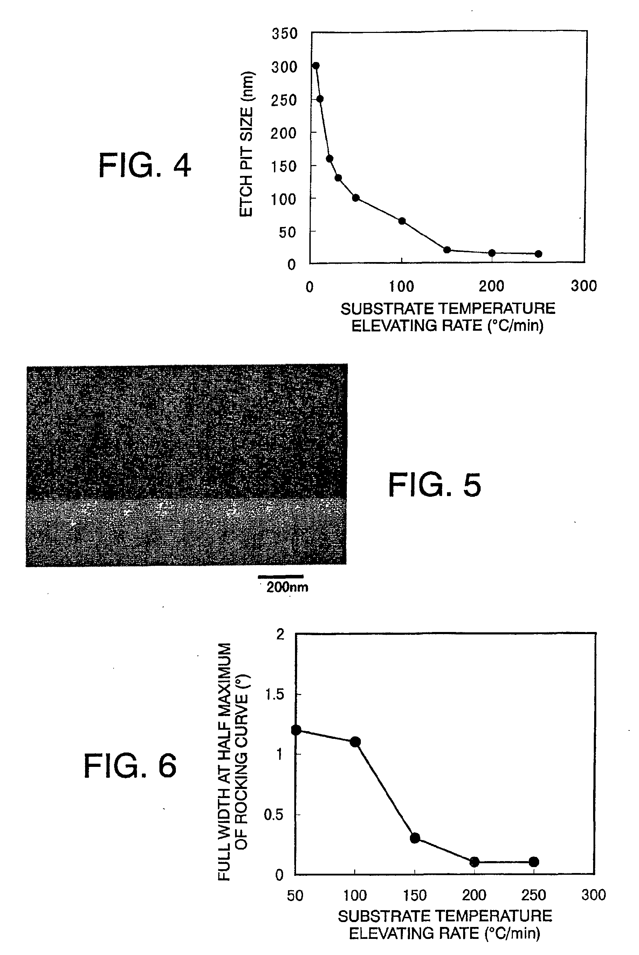

Fig. 4 shows a relationship between the temperature elevating rate and the size of the etch pits formed on the surface of the SiC layer. In the manner similar to that described in conjunction with Fig. 3, the Si substrate was heated up to 1100°C in a C₂H₂ atmosphere by changing the temperature elevating rate.

As illustrated in Fig. 4, if the temperature elevating rate is equal to or higher than 150°C/minute, the size of the etch pits formed on the surface of the SiC layer is remarkably reduced so that the SiC layer with high-quality is formed. From the above, it is understood that the temperature elevating rate of 150°C/minute or more is desirable.

The supply quantity of the raw material will be determined as follows. Specifically, according to the kinetic molecular theory, the collision rate of raw material molecules, namely, the number of molecules colliding with other molecules per unit time, is proportional to the square of the molecular density in the reaction chamber. Taking this into consideration, the partial pressure of the raw material is increased to raise the collision rate with the impurity, thereby further reducing the frequency at which the impurity reaches the substrate. Thus, the effect of this invention becomes more remarkable.

According to this invention, the partial pressure of the raw material is practically set to at least 100 times that of the partial pressure of the impurity. Consequently, the collision rate becomes equal to 1/10000. This remarkably reduces the frequency at which the impurity reaches the substrate.

As described above, the substrate is heated at the rate of 150°C/minute or more, and the partial pressure of the raw material is set to at least 100 times that of the impurity. In this manner, it is possible to form the high-quality SiC layer which is remarkably low in density of etch pits and in density of the dome-like protrusions. The density of the defect, such as the etch pits or the dome-like protrusions, formed on the surface of the SiC layer produced according to this invention is substantially equal to 10²/cm² or lower.

As regards the raw material gas, the carbon source is at least one selected from the group consisting of CₙH₂ₙ (2≦n≦3), CₙH₂ₙ₊₂ (1≦n≦3), CₙH₂ₙ₋₂ (1 ≦n≦3), CCl₄, CHF₃, and CF₄. The Si source is at least one selected from the group consisting of SiH₂Cl₂, SiH₄, SiCl₄, SiHCl₃, Si₂H₆, and Si₂Cl₆.

Alternatively, the raw material gas may be at least one selected from the group consisting of Si(CH₃)₄, SiH₂(CH₃)₂, SiH(CH₃)₃, Si₂(CH₃)₆, (CH₃)₃SiCl, and (CH₃)₂SiCl₂. Particularly, in case where the single crystal Si is used as the substrate, the SiC layer can be formed only by supplying the raw material gas of the carbon.

According to this invention, SiC is deposited on the single crystal SiC layer low in density of the defect by the vapor phase growth method or the liquid phase growth method. Such SiC is formed as a high-quality crystal because the surface structure and the crystallinity of the single crystal SiC layer low in density of the defect are reflected.

In the SiC growth by CVD, at least two kinds of gases serving as the Si source and the carbon source or at least one raw material gas containing both Si and carbon are/is decomposed by heat or plasma to be reacted in the vapor phase or on the substrate surface, thus forming SiC on the substrate surface. The raw material gas used herein may be the same gas as that used in the above-mentioned formation of the SiC layer.

In the SiC growth by LPE, Si is melted in a carbon crucible heated to 1500°C into a Si melt. Then, the surface of the single crystal SiC layer (a seed crystal) according to this invention is contacted with the surface of the melt. As a consequence, SiC is grown on the seed crystal by the melted Si and floating carbon in the melted Si.

Further, a SiC mass (ingot or a structural body) is formed on the single crystal SiC layer by the vapor phase growth method or the liquid phase growth method. The SiC mass has a high quality because the surface structure and the crystallinity of the single crystal SiC layer low in density of the defect is reflected. An SiC mass obtained in the conventional method has an aperture of about 3 inch at most. By contrast, the SiC mass having an aperture of 4 inch to 6 inch or more can be formed by using the above-mentioned production method (namely, the vapor phase growth method or the liquid phase growth method) according to this invention.

Further, the SiC mass produced by the aforementioned method can be used as a substrate in a semiconductor device according to this invention. For example, the semiconductor device is a power device, such as a shottky-barrier diode, or a light-emitting device, such as a blue light emitting diode. Herein, it should be noted that the semiconductor device according to this invention includes a composite material obtained by forming GaN or diamond on SiC.

In the method of this invention, the substrate may be heated by a cold wall method for heating only the substrate and, alternatively, can be heated by a hot wall method for entirely heating the inside of the chamber. In case of the cold wall method, only the substrate is rapidly heated before the inside of the chamber is sufficiently heated. Thus, the single crystal SiC layer can be formed before the impurity attached to a chamber wall is volatilized to float in the chamber.

It is preferable that the raw material for forming the single crystal SiC layer is supplied from the beginning of the single crystal SiC layer formation step. Specifically, from the beginning (normally, the room temperature) of the single crystal SiC layer formation step, the raw material gas is supplied at a flow rate sufficient to achieve a predetermined partial pressure or more. In this event, the substrate surface is covered with the raw material gas. It is therefore possible to further prevent the impurity from reaching the substrate during heating.

The substrate is heated at a predetermined temperature elevating rate or more from the etching start temperature Te to a SiC forming temperature at which SiC (silicon carbide) is formed on the substrate surface. It is desirable that the temperature elevating rate is also high from the beginning (normally, the room temperature) of the single crystal SiC formation step until the etching start temperature Te is reached. In other words, the substrate is preferably heated at the predetermined temperature elevating rate or higher from the beginning of the SiC layer formation step until such the SiC forming temperature is reached.

### [Examples]

Hereinafter, description will be made about several examples according to this invention.

### (First Example)

In this example, a cold wall type CVD apparatus was employed. A single crystal Si substrate with a {001} plane was heated in a mixed atmosphere of C₂H₂ and H₂ to deposit the SiC layer on the substrate.

Explanation will hereinafter be made about the first example in more detail.

At first, the etching start temperature Te of the Si substrate was measured. The measurement of Te was carried out by the use of the quadrupole mass spectrometer, as illustrated in Fig. 2. As a result of the measurement, the etching start temperature Te of the Si substrate was equal to 800°C.

Subsequently, measurement was made of the partial pressure of the impurity in the reaction chamber of the cold wall type CVD apparatus used in this invention. This measurement was also performed by the use of the aforementioned quadrupole mass spectrometer.

As a result of the measurement, the partial pressure of the impurity fell within the range between 1 × 10⁻⁵ Torr and 5 × 10⁻⁵ Torr in a temperature range between 800°C and 1100°C. Accordingly, in order to achieve the effect of this invention, the supply quantity of the raw material gas and the C₂H₂ partial pressure during heating the substrate were selected as follows: 20 sccm as the C₂H₂ flow rate, 100 sccm as the H₂ flow rate, and 6 × 10⁻³ Torr as the C₂H₂ partial pressure.

Next, the single crystal Si substrate having a {001} plane was placed in the cold wall type CVD apparatus and heated via a susceptor arranged on a carbon heater. Here, the heating was carried out at a constant rate of 150°C/minute starting from the room temperature. The substrate was heated until the temperature of the substrate surface reached 1350°C.

In this case, C₂H₂ as the raw material gas and H₂ as a carrier gas were supplied onto the substrate surface from the initial stage at the room temperature. The flow rate and the partial pressure were 20 sccm as the C₂H₂ flow rate, 100 sccm as the H₂ flow rate, and 6 × 10⁻³ Torr as the C₂H₂ partial pressure, as described above.

After the substrate surface reached 1350°C, the substrate was retained for 5 minutes in the above-mentioned mixed atmosphere of C₂H₂ and H₂ to thereby form the single crystal SiC layer to a thickness of about 10 nm.

Prior to the step of growing SiC on the single crystal SiC layer, the surface of the single crystal SiC layer was observed in order to verify the effect of this invention. Fig. 5 shows a SEM image of the surface of the single crystal SiC layer formed on the Si substrate surface.

As apparent from Fig. 5, no etch pit was observed at an interface between the single crystal SiC layer and the Si substrate. The surface roughness of the single crystal Si layer was measured by the use of AFM (Atomic Force Microscope). As a result, the surface roughness (Ra) was equal to 0.1 nm. The density of the etch pits and the dome-like protrusions on the flat surface of the single crystal SiC layer was 80/cm².

The growth of SiC was carried out as follows. After the single crystal SiC layer was formed in the above-mentioned manner, C₂H₂ was intermittently supplied at an interval of one second while H₂ and SiH₂Cl₂ were continuously supplied at a temperature of 1350°C. In this event, the H₂ flow rate was 100 sccm, the SiH₂Cl₂ flow rate was 50 sccm, and the C₂H₂ flow rate was 15 sccm. The pressure during growth was adjusted by a pressure-adjusting valve placed between a reaction chamber and a pump. Specifically, the pressure was set to 0.1 Torr in the mixed atmosphere of C₂H₂ and H₂.

The growth was carried out under the above-mentioned growth condition for 8 hours to thereby grow 3C-SiC having a thickness of 100 µm on the single crystal SiC layer formed on the Si substrate. Then, the planar defect on the surface of SiC was observed by the use of the Nomarski microscope. As a result, the planar defect density observed on the SiC surface formed in this example was 9 × 10²/cm ². The electron mobility in SiC measured by the hole effect was 400 cm²/V/s at the room temperature.

Moreover, X-ray rocking curve measurement was carried out in order to judge the crystallinity of SiC. The measurement was performed for a cubic SiC (200) peak. A full width at half maximum of the rocking curve for the cubic SiC (200) peak of SiC grown in the above-mentioned manner was 0.05 degree.

### (Second Example)

In this example, SiC was grown in the same manner as the first example except that the temperature elevating rate at which the substrate is heated was set to 50°C/minute, 100°C/minute, 150°C/minute, 200°C/minute, and 250°C/minute to form the single crystal SiC layers at the respective rates.

Fig. 6 shows variation of the full width at half maximum of the rocking curve of 3C-SiC(200) peak obtained by the X-ray diffraction measurement with respect to the substrate-heating rate. As apparent from the figure, the full width at half maximum of the rocking curve was rapidly reduced when the heating rate reached 150°C/minute or higher.

As will be understood from the result of the measurement of the X-ray rocking curve, when the substrate heating rate reached 150°C/minute or higher, the etching of the substrate surface was extremely suppressed, so that the SiC layer with high quality could be formed and, consequently, the defect of SiC grown on the SiC layer was reduced also.

### (First Comparative Example)

In this comparative example, the single crystal SiC layer was formed and SiC was grown in the same manner as the first example except that the temperature elevating rate upon heating the substrate was set to 10°C/minute.

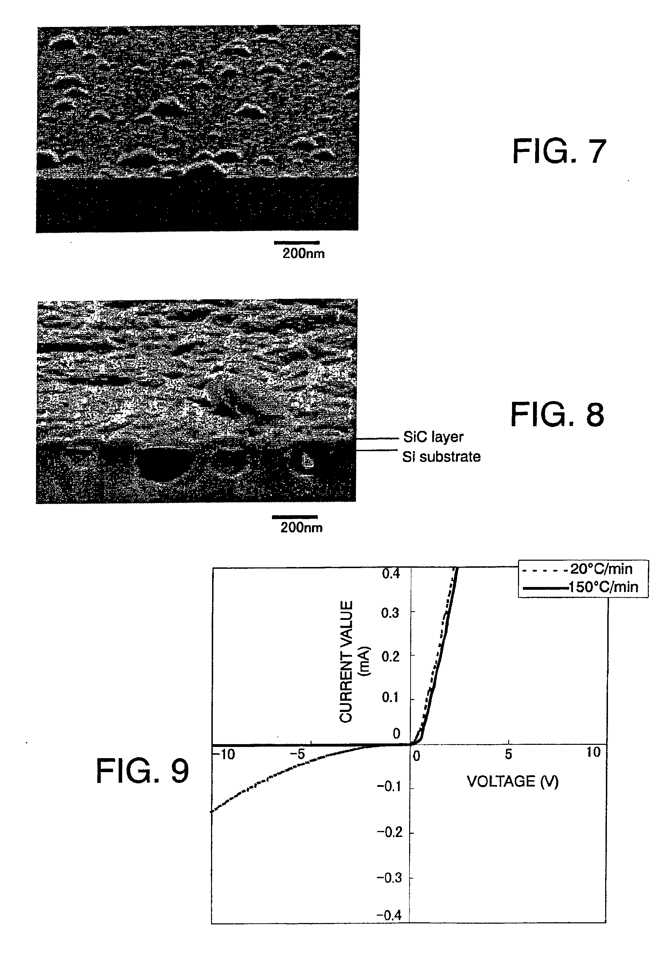

Fig. 7 shows a SEM image in the vicinity of the surface of the single crystal SiC layer formed on the surface of the Si substrate by the use of the method according to the first comparative example. From the figure, it is seen that the dome-like protrusions having an indefinite shape were formed at a high density on the surface of the single crystal SiC layer. Specifically, the density of the dome-like protrusions was 10³cm⁻² on the surface of the single crystal SiC layer.

The planar defect of the SiC surface was observed by the use of the Nomarski microscope. As a result, the planar defect density observed on the SiC surface formed by the conventional method was 5 × 10³/cm². The electron mobility in SiC at the room temperature was measured by the use of the hole effect. As a result, the electron mobility was 10 cm²/V/s.

Further, the crystallinity of SiC was evaluated by the X-ray rocking curve measurement. The measurement was carried out for a 3C-SiC (200) peak. As a result, the full width at half maximum of the rocking curve for 3C-SiC (200) peak grown by this method was 1.0 degree.

### (Second Comparative Example)

In this comparative example, the single crystal SiC layer was formed and SiC was grown in the same manner as the first example except that the temperature elevating rate upon heating the substrate was set to 3°C/minute.

Fig. 8 shows a SEM image in the vicinity of the surface of the single crystal SiC layer formed on the surface of the Si substrate in the second comparative example. As apparent from Fig. 8, the etch pits exist at the interface between the single crystal SiC layer and the Si substrate. Further, the surface of the SiC layer was extremely rough. In this case, the film thickness of the SiC layer was 0.5 µm.

The X-ray rocking curve measurement was carried out in order to judge the crystallinity of SiC. The measurement was performed for a 3C-SiC (200) peak. However, no peak corresponding to the 3C-SiC (200) peak could be detected from SiC grown in this method. In other words, SiC grown by the method of the second comparative example had a polycrystal structure.

### (Third Example)

A schottky-barrier diode was produced by using SiC obtained according to this invention. The production method will hereinafter be explained. At first, SiC was grown on the single crystal SiC layer formed on the Si substrate while N₂ is added. The growth of SiC was carried out by intermittently supplying C₂H₂ while H₂, SiH₂Cl₂ and N₂ are continuously supplied. In this event, H₂ flow rate was100 sccm, SiH₂Cl₂ flow rate was 50 sccm, N₂ flow rate was 100 sccm, and C₂H₂ flow rate was 15 sccm. The pressure during growth was set to 0.1 Torr in the mixed atmosphere of C₂H₂ and H₂.

Under the aforementioned growth condition, the growth was carried out for 8 hours to thereby grow 3C-SiC having a thickness of 100 µm. In this case, atomic concentration of N in SiC was 10²⁰ cm⁻³.

Subsequently, SiC, with no impurity added thereto, was formed on the above-mentioned SiC by the use of homo-epitaxial growth. The growth of SiC was performed at 1350°C by intermittently supplying C₂H₂ at an interval of one second while H₂ and SiH₂Cl₂ were continuously supplied. In this event, H₂ flow rate was 100 sccm, SiH₂Cl₂ flow rate was 50 sccm, and C₂H₂ flow rate was 15 sccm. The pressure during growth was set to 0.1 Torr in the mixed atmosphere of C₂H₂ and H₂.

Under the aforementioned growth condition, the growth was carried out for 1 hour to thereby grow a 3C-SiC homo-epitaxial layer having a thickness of 12.5 µm. In this case, the carrier density in SiC was 8 × 10¹⁴ cm⁻³.

Further, SiC having the homo-epitaxial layer and formed on the Si substrate was dipped in a mixed solution of nitric acid and hydrofluoric acid so that the Si substrate was dissolved and removed. It is noted here that the SiC surface was not polished. Moreover, electrodes were formed on both surfaces of SiC with the homo-epitaxail layer. A Pt electrode was formed on the homo-epitaxial layer. A Ni electrode was formed on the SiC surface. Herein, each of the electrodes had an area of 50 µm φ.

Fig. 9 shows electrical characteristics of a junction of a schottky-barrier diode according to the third example. A dotted line in the figure indicates the electrical characteristic related to the schottky-barrier diode using SiC grown after forming the SiC layer at the heating rate of 20°C/minute.

As apparent from Fig. 9, a reverse leakage current was remarkably reduced in the schottky-barrier diode by setting the heating rate of the substrate to 150°C/minute according to this invention. The reduction of the leakage current shows that the high heating rate results in reduction of the defect density in the SiC layer and in SiC as well as flatness of the SiC surface.

### (Fourth Example)

In this example, diamond or GaN was formed on the SiC obtained in the first or the second example to thereby obtain a composite material.

The diamond can be formed on the SiC via the following steps. After SiC formed in the aforementioned examples was heated in the vacuum reaction chamber up to 500°C. Thereafter, the raw material gas was introduced into the reaction chamber. Commercial propane was used as the raw material gas of the diamond. After SiC was heated up to 500°C, high frequency wave (200W) of 13.56 MHz was applied between SiC and planar electrodes faced to SiC to thereby form plasma. Carbon was decomposed by the plasma and deposited on SiC to be placed at a proper crystal position. In this manner, formation of diamond on SiC was realized. The diamond thus formed was a cubic crystal like SiC serving as a base substrate of growth with the surface having a (001) plane.

On the other hand, GaN could be formed on SiC via the following steps. After SiC formed in the above-mentioned examples was heated up to 1000°C in the vacuum reaction chamber, the raw material gas was supplied in the reaction chamber to thereby form GaN. In this event, Ga(CH₃)₃ was used as the raw material of Ga and supplied by bubbling. The flow rate of Ga(CH₃)₃ was set to 2.5 × 10⁻⁶ mol/minute. Moreover, NH₃ was used as the raw material of nitrogen. The flow rate of NH₃ was set to 5 liter/minute. H₂ gas was used as the carrier gas. The flow rate of H₂ was se to 5 liter/minute. GaN thus formed was a cubic crystal like SiC serving as a base substrate of growth with the surface having a (001) plane.

Au and Ni electrodes were formed on the above-mentioned composite material comprising SiC and diamond formed thereon to produce a schottky barrier diode. Further, the blue color light emitting diode was produced by using the above-mentioned composite material comprising SiC and GaN formed thereon.

Both the schottky-barrier diode and the blue color light emitting diode produced in the above-mentioned manner exhibited excellent characteristics as the semiconductor device. Appearance of such excellent semiconductor characteristics indicates that diamond or GaN having high quality, namely, low defect density similar to that of SiC was formed by using SiC having high quality as the substrate.

As described above, the single crystal SiC is produced on the substrate surface. As a first step, the thin single crystal SiC layer is formed on the substrate surface by heating the substrate under existence of the raw material containing C. Herein, the raw material may contain C and Si as desired. As a second step, SiC is deposited on the single crystal SiC layer by the vapor phase growth method or the liquid phase growth method.

In the step of forming the single crystal SiC layer, the raw material is supplied in the vicinity of the surface of the substrate. The raw material in the vicinity of the surface of the substrate is given a partial pressure higher at a predetermined rate than that of the impurity. Thus, the impurity is prevented from reaching the substrate surface, so that the substrate surface is prevented from being etched by the impurity.

Consequently, the planar defect density of SiC is reduced. Thus, the single crystal SiC, the SiC semiconductor device, and the SiC composite material can be manufactured with high quality and excellent productivity by the use of the production method according to this invention.

While this invention has thus far been disclosed in conjunction with several embodiments thereof, it will be readily possible for those skilled in the art to put this invention into practice in various other manners.

## Claims

1. A method for manufacturing a single crystal SiC on a substrate having a surface, comprising the steps of:
forming a thin single crystal SiC layer on the surface by heating the substrate under existence of a raw material containing C or C and Si; and
depositing SiC on the single crystal SiC layer by the vapor phase growth method or the liquid phase growth method;
the step of forming the single crystal SiC layer being carried out in the manner such that the raw material is supplied in the vicinity of the surface of the substrate, and that the raw material in the vicinity of the surface of the substrate is given a partial pressure higher at least by a predetermined rate than that of an impurity, thereby suppressing the impurity from reaching the surface of the substrate and preventing the surface of the substrate from being etched by the impurity.

2. A method as claimed in claim 1, wherein:
heating in the step of forming the single crystal SiC layer comprises a temperature elevating step of elevating the temperature of the substrate from a first temperature Te at which etching of the surface of the substrate by the impurity is started to a second temperature not lower than a temperature at which the single crystal SiC layer is formed, the temperature elevating step being carried out on such a condition that the partial pressure of the raw material is adjusted to a level not lower than 100 times that of the impurity, and
the temperature elevating step being carried out by selecting at least one of a temperature elevating rate and a temperature elevating time within a range such that the density and the size of a defect such as etch pits or dome-like protrusions is suppressed to prevent occurrence of a planar defect on SiC which is deposited on the single crystal SiC layer by the vapor phase growth method or the liquid phase growth method.

3. A method as claimed in claim 1 or 2, wherein:
at least one material selected from the group consisting of CₙH₂ₙ (2≦n ≦3), CₙH₂ₙ₊₂ (1≦n≦3), CₙH₂ₙ₋₂ (1≦n≦3), CCl₄, CHF₃, and CF₄ is used as the material containing C and used in the step of forming the single crystal SiC layer.

4. A method as claimed in claim 1 or 2, wherein:
at least one material selected from the group consisting of SiH₂Cl₂, SiH₄, SiCl₄, SiHCl₃, Si₂H₆, and Si₂Cl₆ is used as the material containing Si and used in the step of forming the single crystal SiC layer in addition to the material containing C.

5. A method as claimed in claim 1 or 2, wherein: at least one material selected from the group consisting of Si(CH₃)₄, SiH₂(CH₃)₂, SiH(CH₃)₃, Si₂(CH₃)₆, (CH₃)₃SiCl, and (CH₃)₂SiCl₂ is used as material containing C and Si used in the step for forming the single crystal SiC layer.

6. A single crystal SiC, wherein:
the single crystal SiC is obtainable by a method claimed in any one of Claims 1 through 5, and
the planar defect density of a topmost surface falls within a range not higher than 10³/cm⁻².

7. A single crystal SiC, comprising:
a single crystal SiC obtainable by a method claimed in any one of Claims 1 through 5, and
another SiC deposited on the single crystal SiC by the vapor phase growth method or the liquid phase growth method.

8. A semiconductor device, wherein:
the semiconductor device comprises SiC having a predetermined concentration of dopant, and
the dopant is added by ion implantation into the single crystal SiC produced by a method claimed in any one of claims 1 through 5 or as defined in claim 6 or 7.

9. A semiconductor device, wherein:
the semiconductor device comprises SiC having a predetermined concentration of dopant, and
the dopant is added into the SiC in the SiC deposition step claimed in claim 1.

10. A SiC composite material, comprising:
single crystal SiC produced by a method claimed in any one of claims 1 through 5 or as defined in claims 6 or 7, and
diamond or GaN formed on the single crystal SiC.
